Europäisches Patentamt

European Patent Office

Office européen des brevets

(11) Publication number: **0 171 929**
**B1**

(12) EUROPEAN PATENT SPECIFICATION

(45) Date of publication of patent specification: **27.12.89**

(21) Application number: **85305007.8**

(22) Date of filing: **12.07.85**

(51) Int. Cl.⁴: **G 11 B 7/12**

(54) Tracking error detecting apparatus.

(30) Priority: **12.07.84 JP 144927/84**
**13.07.84 JP 145766/84**
**30.04.85 JP 92814/84**
**30.04.85 JP 92815/84**

(43) Date of publication of application:
**19.02.86 Bulletin 86/08**

(45) Publication of the grant of the patent:
**27.12.89 Bulletin 89/52**

(84) Designated Contracting States:
**DE FR GB IT NL**

(56) References cited:
**EP-A-0 107 461**
**EP-A-0 109 194**
**EP-A-0 133 027**
**FR-A-2 360 957**

**PATENT ABSTRACTS OF JAPAN, vl. 6, no. 51,**
**(P-108)929r, 6th Aprl 182; & JP - A - 56 16 3532**
**(MATSUSHITA) 16-12-1981**

(73) Proprietor: **SONY CORPORATION**
**7-35 Kitashinagawa 6-Chome Shinagawa-ku**
**Tokyo 141 (JP)**

(72) Inventor: **Fukumoto, Atsushi c/o Sony**
**Corporation**
**Patents Division 6-7-35 Kitashinagawa**
**Shinagawa-ku Tokyo 141 (JP)**
Inventor: **Ohsato, Kiyoshi c/o Sony Corporation**
**Patents Division 6-7-35 Kitashinagawa**
**Shinagawa-ku Tokyo 141 (JP)**
Inventor: **Terayama, Yasunori c/o Sony**
**Corporation**
**Patents Division 6-7-35 Kitashinagawa**
**Shinagawa-ku Tokyo 141 (JP)**

(74) Representative: **Cotter, Ivan John et al**
**D. YOUNG & CO. 10 Staple Inn**
**London WC1V 7RD (GB)**

(56) References cited:
**PATENT ABSTRACTS OF JAPAN, vol. 6, no. 145**
**(P-132)1023r, 4th August 1982; & JP - A - 57**
**66537 (SHARP) 22-04-1982**

**EP  0 171 929  B1**

**References cited:**

**PATENT ABSTRACTS OF JAPAN, vol. 8, no. 60 (P-262)1497r, 22nd March 1984; & JP - A - 58 208 948 (MITSUBISHI) 05-12-1983**

**PATENT ABSTRACTS OF JAPAN, vol. 8, no. 157, (P-288)1594r, 20th July 1984; & JP - A - 59 54040 (TOKYO SHIBAURA) 23-03-1984**

**PATENT ABSTRACTS OF JAPAN, vol. 8, no. 233 (P-309)1670r, 26th October 1984; & JP - A - 59 110 048 (HITACHI) 25-06-1984**

# EP 0 171 929 B1

**Description**

This invention relates to tracking error detecting apparatus for an optical head. More particularly, but not exclusively, the invention relates to tracking error detecting apparatus for an optical head for use with an optical recording apparatus, an optical reproducing apparatus, or an optical recording and/or reproducing apparatus.

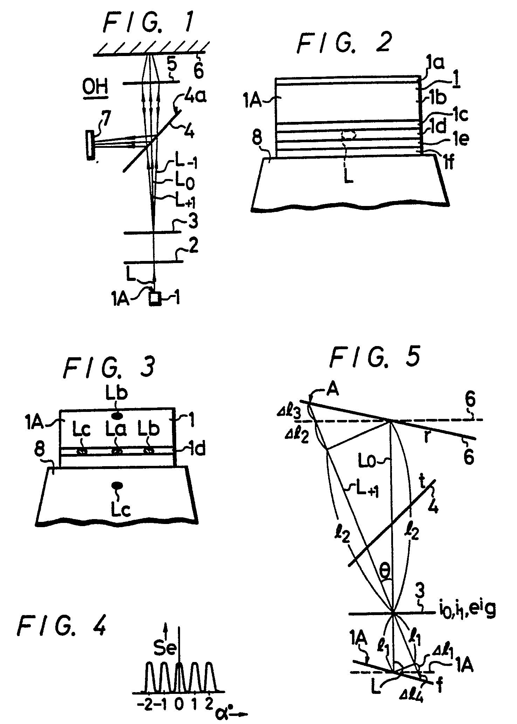

Figure 1 of the accompanying drawings is a diagram showing an example of a previously proposed tracking error detecting apparatus for an optical head OH. In Figure 1, a divergent laser beam L which is of elliptical-shape in cross section is emitted from a laser light emission end face 1A of a semiconductor laser apparatus 1, which includes a laser diode, and is incident on a collimator lens 2 (which may be omitted as required) in which it is collimated as a parallel beam. The parallel beam is then incident on a diffraction grating 3. The diffraction grating 3 produces a zero-order beam $L_0$ and $\pm$ (positive and negative) first-order beams $L_{+1}$ and $L_{-1}$. (Beams of order higher than positive second-order or lower than negative second-order are neglected). These beams travel through a non-polarizing beam splitter (half mirror) 4 and then are incident on an objective lens 5 so as thereby to be converged. (If, instead, a polarizing beam splitter 4 is used, a 1/4 wavelength plate is provided between the beam splitter and the objective lens 5). The converged zero-order beam $L_0$ and $\pm$ first-order beams $L_{+1}$ and $L_{-1}$ are made incident on a recording surface of an optical disc 6 used as an optical recording medium (which expression includes a magneto-optical recording medium) with a predetermined spacing (for example 10 microns) therebetween.

The zero-order beam $L_0$ and the $\pm$ first-order beams $L_{+1}$ and $L_{-1}$ are reflected by the optical recording disc 6, travel through the objective lens 5 and reach the beam splitter 4, whereupon part of them is reflected by a reflecting surface 4a of the beam splitter 4 and thereby made incident on a photo-detector 7. The photo-detector 7 is formed of three photo-detecting sections to permit the zero-order beam $L_0$ and the $\pm$ first-order beams $L_{+1}$ and $L_{-1}$ to become incident thereon separately.

In the case of a tracking error detecting method known as a so-called three spots method, it is possible to obtain a tracking error signal which corresponds to the tracking state of the zero-order beam $L_0$ on the recording surface of the optical disc 6 by calculating the difference between photo-detected outputs from a pair of the photo-detecting sections on which the $\pm$ first-order beams $L_{+1}$ and $L_{-1}$ are incident. A reproduced signal, a focussing error signal and so on can be produced from the photo-detecting section on which the zero-order beam $L_0$ is incident.

Japanese Patent Application No. 59/215860 discloses an improved tracking error signal detecting method based on a so-called push-pull method. In this known method, either a zero-order beam and one of two side beams provided at respective sides of the zero-order beam are used, or all three of the beams are used.

More specifically, this method uses a photo-detector for the three beams which is divided into two equal photo-detecting sections. Further, the apparatus is so arranged that, when a beam spot formed by the zero-order beam lies on the track of the optical disc, beam spots produced by the side beams at respective sides of the zero-order beam lie on lands or are formed with a displacement of 1/2 track pitch. Accordingly, outputs based on the difference between the detected outputs from the respective photodetecting sections of the photo-detector relative to the beam spots, or push-pull outputs, become opposite in phase with respect to the beam spots formed by the zero-order beam and the $\pm$ first-order beams, whereas $d\,c$ fluctuation components produced in the push-pull outputs by lateral displacement of the objective lens and skew of the disc become of the same phase.

Accordingly, if the difference between the push-pull output $PP_0$ from the photo-detector relative to the zero-order beam and the push-pull output $PP_1$ or $PP_2$ from the photo-detector for the + first-order beam or the − first-order beam is calculated, then, regardless of the lateral displacement of the objective lens and the skew of the optical disc, it is possible to obtain a tracking error signal which has no $d\,c$ fluctuation components.

Using all three push-pull outputs $PP_0$, $PP_1$ and $PP_2$, it is also possible to obtain a tracking error signal by calculating the quantity $PP_0-(G_1\,PP_1+G_2\,PP_2)$, where $G_1$ and $G_2$ represent constants which are determined by considering a difference between the gains of the photo-detectors.

An example of the semiconductor laser apparatus 1 will now be described with reference to Figure 2. Referring to Figure 2, the semiconductor laser apparatus 1 is generally fixed to a header portion 8 made of metal such as copper and so on which serves as one electrode and which acts as a heat sink. In other words, in this example, the header portion 8 is formed of only the heat sink.

A laser chip of the semiconductor laser apparatus 1 is of a multilayer construction and will now be described in the order from the upper layer to the lower layer. The chip comprises an electrode layer 1a, an n-GaS layer (substrate layer) 1b, an n-$Ga_{1-y}Al_yAs$ layer (cladding layer) 1c, a $Ga_{1-x}Al_xAs$ layer (active layer) 1d, a p-$Ga_{1-y}Al_yAs$ layer (cladding layer) 1e and a p-GaAs layer 1f. The above-mentioned laser beam L is oscillated or emitted out from the active layer 1d. If the laser beam emission end face (wall surface) 1A of the semiconductor laser apparatus 1 is considered to be the front, the width thereof is in a range of from 100 to 300 microns, the height (thickness) thereof is in a range of from 80 to 100 microns, and the depth thereof is in a range of from 200 to 300 microns. The height of the active layer 1d from the upper surface of the header portion 8 is several microns.

3

In practice, it has been found that, not only for the three spots tracking error detecting method but also for the improved push-pull tracking error detecting method, if, in the optical disc, there is skew in the tangential direction thereof, a $dc$ fluctuation is produced in the tracking error signal so that it is not possible to detect the tracking error precisely.

After various researches, the present inventors and others have suggested the following causes.

Referring to Figure 1, the zero-order beam $L_0$ and the $\pm$ first-order beams $L_{+1}$ and $L_{-1}$ reflected from the otpical disc 6 travel through the objective lens 5 and are then reflected from the reflecting surface 4a of the beam splitter 4. Also, they travel through the beam splitter 4 and reach the diffraction grating 3 which produces the corresponding zero-order beam $L_0$ and the $\pm$ first-order beams $L_{+1}$ and $L_{-1}$, separately. Then, they travel through the collimator lens 2 and reach the semiconductor laser apparatus 1. The amount of the laser beam incident on the semiconductor laser apparatus 1 is large when a non-polarising beam splitter is used and small when a polarizing beam splitter is used. In this case, in accordance with the relative angular position between the laser beam emission end face 1A of the semiconductor laser apparatus 1 and the diffraction grating 3, there are cases in which a central beam La and side beams Lb and Lc at the opposite sides of the central beam La that are incident on the semiconductor laser apparatus 1 are arranged as shown in Figure 3. That is, the central beam La is positioned in the active layer 1d on the end face 1A and the side beams Lb and Lc are positioned in an up and down direction on a straight line passing through the central beam La and perpendicular to the active layer 1d, the central beam La and both side beams Lb and Lc are all positioned in a horizontal direction positioned on the active layer 1d, or the straight line formed by connecting the central beam La and both side beams Lb and Lc is positioned at a desired angular position which is between the above-described two cases. The central beam La and the side beams Lb and Lc are provided by the zero-order beam $L_0$ and $\pm$ first-order beams $L_{+1}$ and $L_{-1}$ being diffracted again by the diffraction grating 3 and superposed in a mixed state.

When at least one of the side beams Lb and Lc is incident on the plane of the header portion 8, since the plane of the header portion 8 is formed to be rough the beam is reflected irregularly. On the other hand, when at least one of the side beams Lb and Lc is incident on the laser beam emission end face 1A of the semiconductor laser apparatus 1, since the end face 1A is of excellent reflectivity (for example, 10%) the beam is reflected from the end face 1A. As described above, the zero-order beam and the $\pm$ first-order beams incident on the semiconductor laser apparatus 1 are reflected therefrom, diffracted again by the diffraction grating 3 and reach to the optical disc 6 so that a complicated interference pattern is formed on the photo-detector 7.

The interference pattern is varied by a difference (phase difference) between the lengths of optical paths of the zero-order beam and the $\pm$ first-order beams. Thus, the interference pattern is varied by a change of the skew angle of the optical disc 6. Accordingly, the tracking error signal is varied by the change of the skew angle $\alpha°$ of the optical disc 6 so as to have a periodicity as, for example, shown in Figure 4. In practice, as $|\alpha|$ is increased, the level of the tracking error signal Se is attenuated. When the side beams Lb and Lc are both incident on the laser beam emission end face 1A, the amplitude of the waveform corresponding to Figure 4 becomes twice the amplitude shown in Figure 4 and the phase thereof becomes different from the phase of Figure 4.

An analysis of the above-described interference pattern will now be given with reference to Figure 5 (from which the lens system is omitted).

Referring to Figure 5, reference 1A shown by a solid line designates the laser beam emission end face which, however, is inclined relative to the laser beam emission end face 1A when positioned at the normal position as shown by a broken line. Further, reference 6 shown by a solid line designates an optical disc. The optical disc 6 has a skew and therefore is inclined relative to the normal position shown by a broken line. The zero-order beam $L_0$ is perpendicular to the laser beam emission end face 1A at the normal position and the recording surface of the optical disc 6 at the normal position. $\theta$ designates the angle of the $+$ first-order beam $L_{+1}$ relative to the zero-order beam $L_0$. $l_1$ designates the optical path length between the laser beam emission end face 1A and the diffraction grating 3. $l_2$ designates the optical path length between the diffraction grating 3 and the recording surface of the optical disc 6. $\Delta l_1$ and $\Delta l_2$ respectively designate optical path length differences between the optical path lengths $l_1$ and $l_2$ of the zero-order beam $L_0$ and $+$ first-order beam $L_{+1}$. $\Delta l_3$ and $\Delta l_4$ respectively designate an optical path difference caused by the skew of the optical disc 6 and an optical path difference caused by the skew of the laser beam emission end face 1A.

Further, $g$ represents the phase difference between the zero-order beam $L_0$ and $+$ first-order beam $L_{+1}$ in the diffraction grating 3, $i_0$ and $i_1$ designate, respectively, the transmittances of the zero-order beam $L_0$ and the first $+$ first-order beam $L_{+1}$ in the diffraction grating 3. Reference $t$ represents the transmittance of the half mirror 4 and $r$ and $f$ represent, respectively, the reflectivities of the recording surface of the optical recording medium 6 and of the laser beam emission end face 1A.

The complex amplitude of light at a point A on the recording surface of the optical disc 6 at which the $+$ first-order beam $L_{+1}$ is incident will be considered separately with respect to the following four cases.

(1) $a_1$: the $+$ first-order beam $L_{+1}$ is incident at the point A, directly.

(2) $a_2$: a zero-order beam which results from reflecting the zero-order beam $L_0$ from the optical disc 6 and introducing it again into the diffraction grating 3 is reflected from the laser beam emission end face 1A and again introduced into the diffraction grating 3 to thereby produce the $+$ first-order beam $L_{+1}$. This $+$ first-order beam $L_{+1}$ is then incident at the point A.

4

(3) $a_3$: a + first-order beam is provided by reflecting the zero-order beam $L_0$ from the optical disc 6 and introducing it again into the diffraction grating 3. This + first-order beam is reflected from the laser beam emission end face 1A and incident again on the diffraction grating 3 to thereby produce the zero-order beam. This zero-order beam is then incident at the point A.

(4) $a_4$: a zero-order beam is provided by reflecting the + first-order beam $L_{+1}$ from the optical disc 6 and introducing it again into the diffraction grating 3. This zero-order beam is reflected from the laser beam emission end face 1A and introduced again into the diffraction grating 3 to thereby produce the zero-order beam. Then, this zero-order beam is made incident at the point A.

The above-described cases $a_1$ to $a_4$ can be expressed by the following equations:

$$a_1 = i_1 t \cdot \exp\{j(l_1 + g + l_2 + \Delta l_2 + \Delta l_3)\} \tag{1}$$

$$a_2 = i_0^2 i_1 t^3 rf \cdot \exp[j\{3(l_1 + l_2) + g + \Delta l_2 + \Delta l_3\}] \tag{2}$$

$$a_3 = i_0^2 i_1 t^3 rf \cdot \exp[j\{3(l_1 + l_2) + g + 2\Delta l_1 + \Delta l_2 + \Delta l_3 + 2\Delta l_4\}] \tag{3}$$

$$a_4 = i_0^2 i_1 t^3 rf \cdot \exp[j\{3(l_1 + l_2) + g + 3(\Delta l_2 + \Delta l_3) + 2\Delta l_1 + 2\Delta l_4\}] \tag{4}$$

In order to simplify the calculations, if the length over which the laser beam can be interfered with is selected to be lower than $2(l_1 + l_2)$, the intensity $I_A$ of light at the point A is expressed by the following equation:

$$\begin{aligned}I_A &= |a_1|^2 + |a_2 + a_3 + a_4|^2 \\ &= i_1^2 t^2 [1 + i_0^4 t^4 r^2 f^2 \{3 + 2\cos\ 2(\Delta l_1 + \Delta l_4) \\ &\quad + 2\cos\ 2(\Delta l_1 + \Delta l_4 + \Delta l_2 + \Delta l_3) + 2\cos\ 2(\Delta l_2 + \Delta l_3)\}]\end{aligned} \tag{5}$$

Further, when the side beams Lb and Lc are both incident on the laser beam emission end face 1A, if the + first-order beam $L_{+1}$ is incident at the point A on the recording surface of the optical disc 6 and the − first-order beam $L_{-1}$ becomes incident on a point B which is symmetrical with respect to the zero-order beam $L_0$, the intensity $I_A$ of the light at the point A is as given by Equation (5), while the intensity $I_B$ of light at the point B is expressed by the following equation:

$$I_B = i_1^2 t^2 [1 + i_0^4 t^4 r^2 f^2 \{3 + 2\cos\ 2(\Delta l_1 - \Delta l_4) + 2\cos\ 2(\Delta l_1 - \Delta l_4 + \Delta l_2 - \Delta l_3) + 2\cos\ 2(\Delta l_2 - \Delta l_3)\}] \tag{6}$$

As described above, a complex interference pattern is produced on the photo-detector 7. In particular, when, relative to the central beam La, both the side beams Lb and Lc are arranged in the vertical direction and the side beam Lb becomes incident on the laser beam emission end face 1A and the side beam Lc becomes incident on the header portion 8, the side beam Lb is reflected from the laser beam emission end face 1A and the side beam Lc is reflected irregularly from the header portion 8 (whose surface is formed to be rough), so that, with respect to both the side beams Lb and Lc which are returned to the semiconductor laser apparatus 1 and then incident on the side of the disc 6 again, there is caused an unbalance, whereby a *d c* fluctuation is produced in the tracking error signal. Similary, a *d c* fluctuation is produced in the tracking error signals produced in the three spots method and the push-pull method as mentioned above.

European Patent Application Publication No. EP—A—0 109 194 discloses a tracking error detecting apparatus for an optical head, the apparatus comprising a semiconductor laser apparatus, a diffraction grating, a beam splitter, an objective lens and a photodetector, these components being so arranged that, in use, a laser beam from the semiconductor laser apparatus is divided by the diffraction grating into a main beam and two side beams on opposite sides of the main beam, the three beams pass through the beam splitter and the objective lens to arrive at an optical recording medium, the beams are reflected from the optical recording medium and pass through the objective lens to the beam splitter where they are transmitted through the beam splitter so as to return towards the semiconductor laser apparatus and are reflected from the beam splitter, and the beams reflected from the beam splitter are incident on the photodetector and detected outputs of at least two beams of the three beams incident on the photo-detector are used to produce a tracking error signal corresponding to the tracking state of the main beam on the optical recording medium.

The present invention provides a tracking error detecting apparatus as just defined, characterised in that the semiconductor laser apparatus is so designed that reflection back towards the diffraction grating, by a laser beam emission end face of the semiconductor laser apparatus, of a side beam of the beams which have been transmitted through the beam splitter and returned towards the semiconductor laser apparatus, is suppressed so as thereby to reduce influence on the tracking error signal of skew of the optical recording medium relative to its normal position perpendicular to the main beam.

Preferred embodiments of this invention described hereinbelow provide a tracking error detecting apparatus in which a tracking error signal indicative of a tracking error of a zero-order beam from an optical head with respect to a track of an optical recording medium can be prevented from being affected by inclination of the optical recording medium in the track direction, or variation of the tangential skew angle thereof.

Tracking error detecting apparatus embodying the invention is suitable for use with an optical recording apparatus, an optical reproducing apparatus, an optical recording and/or reproducing apparatus, and so on.

The invention will now be further described, by way of illustrative and non-limiting example, with reference to the accompanying drawings, in which like references designate like elements and parts throughout, and in which:

Figure 1 is a diagram showing the construction of an optical system of a previously proposed optical head;

Figure 2 is a front view of a previously proposed semiconductor laser apparatus;

Figure 3 is a diagram useful for explaining returned beams of the previously proposed semiconductor laser apparatus;

Figure 4 is a characteristic graph of interference;

Figure 5 is a diagram useful for explaining how the interference occurs; and

Figures 6 to 15 are diagrams showing embodiments of tracking error detecting apparatus according to the present invention.

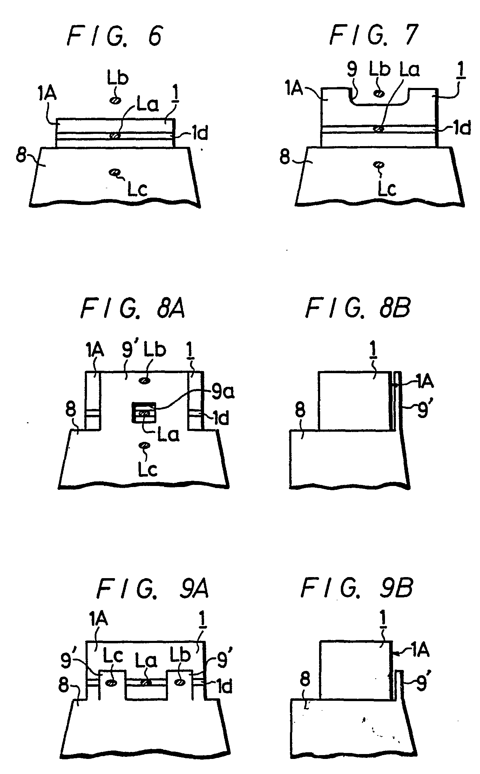

A first embodiment of tracking error detecting apparatus according to the present invention will now be described in detail with reference to Figure 6, in which case the laser beam emission end face 1A of the semiconductor laser apparatus or element 1 is of high reflectivity (for example 10%). In Figure 6 parts corresponding to like parts of Figures 1 to 5 are designated by the same references and will not be described.

Figure 6 shows a case in which the straight line formed by connecting the central beam La and the side beams Lb and Lc, each of which is incident on the semiconductor laser element 1, is made substantially perpendicular to the active layer 1d of the semiconductor laser element 1. In this embodiment, the thickness (height) of the semiconductor laser element 1 is selected to be as thin (low) as about 80 microns so that, of the side beams Lb and Lc, the side beam Lb, which is shown on the upper side of Figure 6, can be prevented from being made incident on the laser beam emission end face 1A. In Figure 6, the beam Lc at the lower side becomes incident on the heat sink 8, from which it is irregularly reflected. (Other parts of the apparatus of Figure 6 are similar to those of Figures 1 to 5).

In consequence, if the beams reflected from the optical recording medium 6 travel through the objective lens 5, the beam splitter 4 and the diffraction grating 3 and then reach the semiconductor laser element 1, there is no risk of the beams being reflected from the laser beam emission end face 1A. Thus, it is possible to obtain a tracking error signal of the zero-order beam from the optical head OH relative to the optical recording medium 6 which can be prevented from being varied due to variation of the tangential skew angle of the optical recording medium 6.

If a problem of strength of the semi-conductor laser element 1 arises due to its being reduced in thickness, then, according to a variation of the first embodiment shown in Figure 7, a groove 9 can be formed at a central portion of the upper surface of the semiconductor laser element 1 so that the upper laser beam Lb can be prevented from being incident on the laser beam emission end face 1A.

If there is a possibility that both the side beams Lb and Lc will become incident on the active layer 1d on the laser beam emission end face 1A, the width of the semiconductor laser element 1 is reduced or such grooves are formed at both sides of the semiconductor laser element 1 in order to avoid such possibility.

A second embodiment of optical tracking error detecting apparatus according to the present invention will now be described with reference to Figures 8A and 8B, in which case the laser beam emission end face 1A of the semiconductor laser element 1 of high reflectivity (for example 10%). In Figures 8A, and 8B parts corresponding to like parts of Figures 6 and 7 are designated by the same references and will not be described.

In this embodiment, a part of the heat sink 8 is extended to form a light shield plate (member) 9' that opposes the laser beam emission end face 1A of the semiconductor laser element 1 with a predetermined spacing therebetween, through which a window 9a is formed at a portion corresponding to the laser beam emitting portion of the active layer or region 1d thereby to enable emission of the laser beam L.

Then, if the laser beams reflected from the optical recording medium travel through the objective lens 5, the beam splitter 4 and the diffraction grating 3 and then are incident on the semiconductor laser element 1, such laser beams are reflected irregulary by the light shield plate 9' so that it is possible to obtain a tracking error signal which can be prevented from being varied due to change of the zero-order beam from the optical head OH by the tangential skew angle of the optical recording medium.

If there is a possibility that both the side beams Lb and Lc will become incident on the laser beam emission end face 1A, then, according to a variation of the second embodiment shown in Figures 9A and 9B, a part of the heat sink 8 can be extended at two places to form a pair of light shield plates 9' which are opposed to the laser beam emission end face 1A of the semiconductor laser element 1 with a predetermined spacing therebetween. The pair of light shield plates 9' are disposed at positions to shield the side beams Lb and Lc from becoming incident on the semiconductor laser element 1.

While it may be possible for the light shield plate 9' for absorbing or shielding the light to be secured to the laser beam emission end face 1A of the semiconductor laser element 1 by bonding or the like, in this case an insulating material is used.

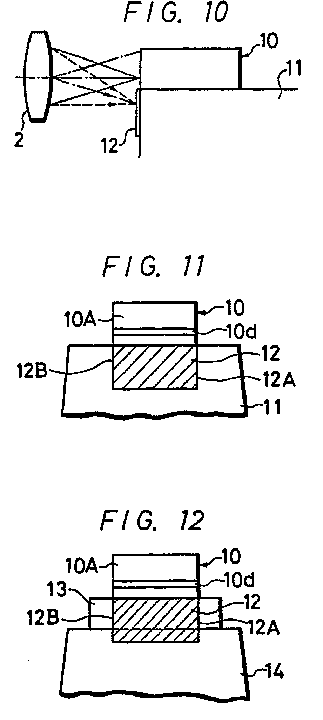

Figures 10 and 11 are diagrams showing a third embodiment of tracking error detecting apparatus according to the present invention. This third embodiment is further improved in that, as for the first and second embodiments, the upper beam Lb can be prevented from being made incident on the laser beam emission end face, or the laser beam emission end face of the semiconductor laser can be of low reflectivity (for example about 2 to 3%), or a laser diode of high output can be used. The embodiment shown in Figures 10 and 11 includes a laser diode chip 10, a header portion 11 made of metal, a laser beam emission end face 10A and an active layer 10d.

In this embodiment, the surface of the header portion 11 on which are incident the side beams that have travelled through the collimator lens 2 along the optical paths shown by broken lines is coated with a non-reflective coating material 12. Accordingly, if the side beam is incident on the header portion 11 at its portion coated with the non-reflecting coating material 12, a reflection thereof can be suppressed so that the side beam can be prevented substantially from becoming incident on the collimator lens 2 once again.

It is not necessary to coat the non-reflective coating material 12 on the whole area of the header portion 11 at its surface opposing the collimator lens 2 in the lateral direction: it is instead possible to coat it only on its portion under the laser diode chip 10 on which the laser beam is incident.

Further, the positions of end sides 12A and 12B in the right-hand and left-hand directions of the portion coated with the non-reflective coating material 12 in Figure 11 can be used as markers for matching the positions of the laser diode chip 10 and the header portion 11 when the laser diode chip is mounted on the header portion. In other words, if the distance between the end sides 12A and 12B is selected to be equal to the width of the laser beam emission end face 10A of the laser diode chip 10, the positions can be matched merely by matching both side ends of the laser diode chip 10 with the end sides 12A and 12B of the non-reflective coating material-coated portion 12. In fact, it is not necessary to use both end sides 12A and 12B as markers: it is sufficient to use one of them as a marker for matching the positions.

The semiconductor laser apparatus 1 is not limited to a structure in which the laser diode chip 10 is mounted directly on the heat sink made of metal, but may be of a structure such as that shown in Figure 12 in which the laser diode chip 10 is mounted on a silicone substrate 13 and then the silicone substrate 13, on which the laser diode chip 10 is mounted, is mounted on a heat sink 14. In other words, in this case, the header portion is formed of the silicone substrate 13 and the heat sink 14.

In the case of a semiconductor laser apparatus having such a structure, there is a possibility that the side beam will become incident not on the heat sink 14 but on the silicone substrate 13. Therefore, in the case of the semiconductor laser apparatus shown in Figure 12, the non-reflective coating material 12 is coated on appropriate portions of the silicone substrate 13 and the heat sink 14.

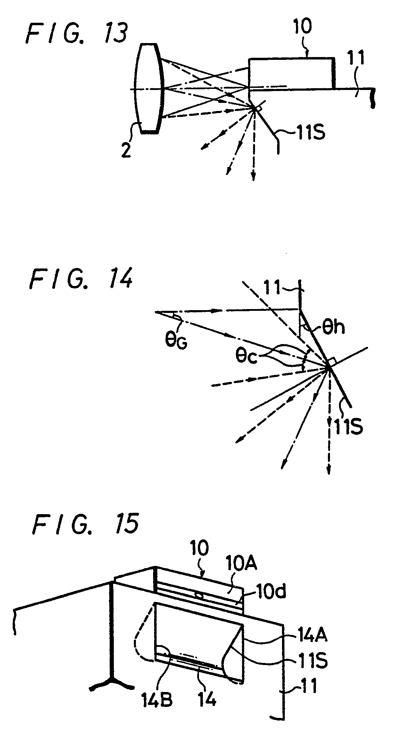

Figure 13 is a diagram showing another embodiment of optical tracking error detecting apparatus according to this invention, in which another form of semiconductor laser apparatus is used. The arrangement shown in Figure 13 includes a laser diode chip 10 and a header portion 11 made of metal.

In this embodiment, as shown in Figure 13, the plane of the header portion 11 on which are incident the side beams, which have passed through the collimator lens 2 along the optical paths shown by broken lines, is inclined as shown at 11S so that the side beams reflected therefrom can be prevented from becoming incident on the collimator lens 2 once again.

In this case, if the surface of the inclined portion 11S is not formed as a rough surface, but is formed as a mirror surface so as to avoid irregular reflection, there can be achieved a significant effect.

Further, as shown in Figure 14, if $\theta_G$ is an angle between the main beam and the side beam, the N.A. (numerical aperture) of the collimator lens 2 is $NA_c$, and the condition $\theta_c = \sin^{-1}NA_c$ and an angle $\theta_h$ between the inclined portion 11S and the plane perpendicular to the main beam is selected to satisfy the following condition

$$\theta_h + \theta_G - \theta_c > 0$$

the reflected light of the side beam from the header portion 11 can be prevented from being made incident on the collimator lens 2.

In this case, it is not necessary to provide the inclined portion 11S over the whole area of the header portion 11 at its surface opposing the collimator lens 2 in the lateral direction. Rather, it is sufficient if, as shown in Figure 15, a concave portion 14 having the inclined portion 11S is provided on the header portion 11 only at the incident portion of the side beam under the laser diode chip 10. In this case, both sides 14A and 14B of the concave portion 14 can be used as markers for matching the positions in the lateral direction when the laser diode chip 10 is mounted on the header portion 11. In other words, if the distance between the sides 14A and 14B is selected to be equal to the width of the end face 10A of the laser diode chip 10, the matching of the positions therebetween can be carried out simply by matching both sides of the laser diode chip 10 with the side edges 14A and 14B of the concave portion 14. Of course, though it is possible to use both the side edges 14A and 14B as markers, it is instead possible for either of them to be used as a marker for matching the positions.

The inclined portion 11S need not be formed rectilinearly, but may be formed as a curved surface.

According to the embodiments of the invention set forth above, since, of the side beams, the reflected beam of the beam incident on the header portion can be prevented from being returned to the optical system again, if it is arranged to suppress the reflected beam at the side of the laser beam emission end face of the laser diode chip, it is possible more effectively to prevent $dc$ fluctuation from being produced in the tracking error signal as a result of skew of the optical disc.

## Claims

1. A tracking error detecting apparatus for an optical head (OH), the apparatus comprising a semiconductor laser apparatus (1), a diffraction grating (3), a beam splitter (4), an objective lens (5) and a photodetector (7), these components being so arranged that, in use, a laser beam (L) from the semiconductor laser apparatus (1) is divided by the diffraction grating (3) into a main beam $(L_0)$ and two side beams $(L_{+1}, L_{-1})$ on opposite sides of the main beam $(L_0)$, the three beams $(L_0, L_{+1}, L_{-1})$ pass through the beam splitter (4) and the objective lens (5) to arrive at an optical recording medium (6), the beams are reflected from the optical recording medium (6) and pass through the objective lens (5) to the beam splitter (4) where they are transmitted through the beam splitter (4) so as to return towards the semiconductor laser apparatus (1) and are reflected from the beam splitter (4), and the beams reflected from the beam splitter (4) are incident on the photodetector (7) and detected outputs of at least two beams of the three beams incident on the photo-detector (7) are used to produce a tracking error signal corresponding to the tracking state of the main beam on the optical recording medium (6), characterised in that the semiconductor laser apparatus (1) is so designed that reflection back towards the diffraction grating (3), by a laser beam emission end face (1A, 10A) of the semiconductor laser apparatus, of a side beam (Lb) of the beams which have been transmitted through the beam splitter (4) and returned towards the semiconductor laser apparatus (1), is suppressed so as thereby to reduce influence on the tracking error signal of skew of the optical recording medium (6) relative to its normal position perpendicular to the main beam $(L_0)$.

2. Apparatus according to Claim 1, wherein the semiconductor laser apparatus (1) is reduced in thickness to thereby prevent the side beam (Lb) from being returned to the laser beam emission end face (1A) whereby reflection of the side beam (Lb) is suppressed.

3. Apparatus according to Claim 2, in which a central portion (9) of the semiconductor laser apparatus (1) is reduced in thickness.

4. Apparatus according to Claim 1, in which the semiconductor laser apparatus (1) is provided with a light-shield plate (9') which prevents the side beam (Lb) from being returned to the laser beam emission end face (1A), whereby reflection of the side beam (Lb) is suppressed.

5. Apparatus according to Claim 1, comprising a header portion (11; 13, 14) coated with a non-reflective coating (12) so as thereby to suppress reflection of the other side beam therefrom.

6. Apparatus according to Claim 5, in which the header portion (11) is provided with an inclined portion (11S) by which the other side beam is prevented from being reflected so as to be incident again on the diffraction grating (3).

## Patentansprüche

1. Vorrichtung zur Ermittlung eines Spurfolgefehlers für einen optischen Kopf (OH) mit einer Halbleiter-Laseranordnung (1), einem Beugungsgitter (3), einem Strahlenteiler (4), einem Objektiv (5) und einem Fotodetektor (7),
wobei diese Komponenten so angeordnet sind, daß im Betrieb ein Laserstrahl (L) der Halbleiter-Laseranordnung (1) von dem Beugungsgitter (3) in einen Hauptstrahl $(L_0)$ und zwei beiderseits dieses Hauptstrahls $(L_0)$ liegende Seitenstrahlen $(L_{+1}, L_{-1})$ aufgeteilt wird,
wobei diese drei Strahlen $(L_0, L_{+1}, L_{-1})$ durch den Strahlenteiler (4) und das Objektiv (5) verlaufen und zu einem optischen Aufzeichnungsmedium (6) gelangen, von diesem reflektiert werden und durch das Objektiv (5) zu dem Strahlenteiler (4) verlaufen, der sie einerseites durchläßt, so daß sie zu der Halbleiter-Laseranordnung (1) zurückkehren, und andererseits reflektiert, so daß sie auf den Fotodetektor (7) auftreffen,
und wobei die Detektorausgangssignale von wenigstens zwei der drei auf den Fotodetektor (7) auftreffenden Strahlen zur Erzeugung eines Spurfolgefehlersignals dienen, das dem Spurzustand auf dem optischen Aufzeichnungsmedium (6) entspricht, dadurch gekennzeichnet,
daß die Halbleiter-Laseranordnung (1) so ausgebildet ist, daß die Reflektion eines Seitenstrahls (Lb) der durch den Strahlenteiler (4) übertragenen und zu der Halbleiter-Laseranordnung (1) zurückkehrenden Strahlen durch eine laserstrahlemittierende Stirnfläche (1A, 10A) der Halbleiter-Laseranordnung (1) zurück zu dem Strahlenteiler (4) unterdrückt und dadurch der Einfluß einer Schiefstellung des optischen Aufzeichnungsmediums (6) relativ zu seiner Normalstellung senkrecht zu dem Hauptstrahl $(L_0)$ auf das Spurfolgefehlersignal verringert wird.

2. Vorrichtung nach Anspruch 1, bei der die Halbleiter-Laseranordnung (1) derart dickenreduziert ist, daß eine Rückkehr des Seitenstrahls (Lb) zu der laserstrahlemittierenden Stirnfläche (1A) verhindert und dadurch die Reflektion des Seitenstrahls (Lb) Unterdrückt wird.

3. Vorrichtung nach Anspruch 2, bei der ein zentraler Teil (9) der Halbleiter-Laseranordnung (1) dickenreduziert ist.

4. Vorrichtung nach Anspruch 1, bei der die Halbleiter-Laseranordnung (1) eine Lichtabschirmplatte (9') aufweist, die verhindert, daß der Seitenstrahl (Lb) zu der laserstrahlemittierenden Stirnfläche (1A) zurückkehrt, wodurch die Reflektion des Seitenstrahls (Lb) unterdrückt wird.

5. Vorrichtung nach Anspruch 1 mit einem Kopfteil (11; 13, 14), das mit einer nichtreflektierenden Beschichtung (12) versehen ist, durch die die Reflektion des anderen Seitenstrahls durch das Kopfteil verhindert wird.

6. Vorrichtung nach Anspruch 5, bei der das Kopfteil (1) eine geneigten Bereich (115) aufweist, der verhindert, daß der andere Seitenstrahl so reflektiert wird, daß er wieder auf das Beugungsgitter (3) auftrifft.

**Revendications**

1. Appareil de détection d'erreur de poursuite de piste destiné à une tête optique (OH), l'appareil comprenant un appareil laser à semiconducteur (1), un réseau de diffraction (3), un séparateur de faisceau (4), une lentille d'objectif (5) et un photodétecteur (7) ces éléments constituants étant ainsi disposés que, en utilisation, un faisceau laser (L) venant de l'appareil laser à semiconducteur (1) est divisé par le réseau de diffraction (3) en un faisceau principal ($L_0$) et deux faisceaux latéraux ($L_{+1}$, $L_{-1}$) se trouvant de part et d'autre du faisceau principal ($L_0$), les trois faisceaux ($L_0$, $L_{+1}$, $L_{-1}$) traversent le séparateur de faisceau (4) et la lentille d'objectif (5) pour arriver en un support d'enregistrement optique (6), les faisceaux sont réfléchis par le support d'enregistrement optique (6) et arrivent, via la lentille d'objectif (5), jusqu'au séparateur de faisceau (4) où ils sont transmis au travers du séparateur de faisceau (4) de manière à revenir vers l'appareil laser à semiconducteur (1) et sont réfléchis par le séparateur de faisceau (4), et les faisceaux réfléchis par le séparateur de faisceau (4) arrivent sur le photodétecteur (7) et les signaux de sortie détectés d'au moins deux faisceaux parmi les trois faisceaux arrivant sur le photodétecteur (7) sont utilisés pour produire un signal d'erreur de poursuite de piste correspondant à l'état de suivi de piste du faisceau principal sur le support d'enregistrement optique (6), caractérisé en ce que l'appareil laser à semiconducteur (1) est ainsi conçu que la réflexion vers l'arrière en direction du réseau de diffraction (3), par une face terminale (1A, 10A) d'émission de faisceau laser de l'appareil laser à semiconducteur, d'un faisceau latéral (Lb) parmi les faisceaux qui ont été transmis au travers du séparateur de faisceau (4) et sont revenus en direction de l'appareil à semiconducteur (1), est supprimée, si bien qu'on réduit l'influence, sur le signal d'erreur de poursuite de piste, de la mise en travers du support d'enregistrement optique (6) par rapport à sa position normale perpendiculaire au faisceau principal ($L_0$).

2. Appareil selon la revendication 1, où l'appareil laser à semiconducteur (1) présente une réduction d'épaisseur de manière à empêcher le faisceau latéral (Lb) d'être renvoyé jusqu'à la face terminale (1A) d'émission de faisceau laser, si bien que la réflexion du faisceau latéral (Lb) est supprimée.

3. Appareil selon la revendication 2, dans lequel une partie centrale (9) de l'appareil laser à semiconducteur (1) présente une réduction d'épaisseur.

4. Appareil selon la revendication 1, dans lequel l'appareil laser à semiconducteur (1) est doté d'une plaque (9') faisant obstacle à la lumière qui empêche que le faisceau latéral (Lb) ne soit renvoyé jusqu'à la face terminale (1A) d'émission de faisceau laser, si bien que la réflexion du faisceau latéral (Lb) est supprimée.

5. Appareil selon la revendication 1, comprenant une partie socle (11; 13, 14) revêtu d'un revêtement non réfléchissant (12), de manière à ainsi supprimer la réflexion de l'autre faisceau latéral par cette partie.

6. Appareil selon la revendication 5, dans lequel la partie socle (11) est dotée d'une partie inclinée (11S) par laquelle l'autre faisceau latéral est empêché de retomber sur le réseau de diffraction (3).

FIG. 1

FIG. 2

FIG. 3

FIG. 5

FIG. 4

# F I G. 6

# F I G. 7

# F I G. 8A

# F I G. 8B

# F I G. 9A

# F I G. 9B

FIG. 10

FIG. 11

FIG. 12

*F I G. 13*

*F I G. 14*

$\theta_G$

$\theta_h$

$\theta_c$

*F I G. 15*